# EUROPEAN PATENT SPECIFICATION

(11) **EP 0 255 360 B1**
(45) Date of publication and mention of the grant of the patent: **19.05.1993**
(21) Application number: 87306706.0
(22) Date of filing: 29.07.1987
(51) Int. Cl.: H03H 9/02

(54) **Quartz crystal for surface acoustic wave device**
Quartzkristall für akustische Oberflächenanordnung
Cristal de quartz pour dispositif à onde acoustique de surface

(30) Priority: 29.07.1986 US 891235
(43) Date of publication of application: 03.02.1988
(73) Proprietor: R.F. MONOLITHICS, INC., Dallas Texas 75244 (US)
(72) Inventor: Andle, Jeffrey C., Dallas Texas 75240 (US)
(74) Representative: Jackson, Peter Arthur

(56) References cited:
- US-A- 4 499 395
- PATENT ABSTRACTS OF JAPAN, vol. 6, no. 234 (E-143)[1112], 20th November 1982; & JP-A-57 135 518 (CLARION K.K.) 21-08-1982

## Description

This invention relates to an optimal acoustic wave propagation orientation on a quartz crystal for surface acoustic wave (SAW) applications including natural single-phase unidirectional transducers.

Surface acoustic wave technology for signal processing has produced a broad range of devices which are used typically in the VHF and UHF range and include filters, resonators, coupled resonators, delay lines, convolvers, impedance elements and various other types of devices. Processes for preparing these devices are well known in the art and the device typically involves interdigitated electrodes.

The orientations for surface acoustic wave propagation for any given crystal are completely defined by the Euler angles, lambda, mu and theta. The first two angles lambda and mu, define the crystal cut and the third angle, theta, defines the direction of acoustic wave propagation in that cut. Thus, acoustic wave propagation orientation in the crystal is defined by a unique set of all three Euler angles. See Goldstein, H., Classical Mechanics, New York, (1950) (Addison-Wesley).

A theoretical tabulation of surface acoustic wave propagation properties at various orientations for a variety of surface wave materials and particular crystal cuts of interest can be generated and tabulated. A tabulation including velocity, coupling coefficient, electromechanical power flow, angle curves, and magnitude and phase of the free surface mechanical displacements and electric surface potential can be found in Microwave Acoustic Handbook IA and 2, Slobodnik et al, Air Force Cambridge Research Labs, October 1973 and October 1974. In addition other properties include the temperature coefficient of delay, spurious bulk responses, diffraction characteristics, dielectric constants and the like. Such data as set forth in these handbooks can be used as a guide to selecting appropriate directions for wave propagation and orientation in the crystal.

The concern in each case in the prior art is to find a crystal orientation which has good coupling between the voltage on the electrodes and the acoustic wave in the crystal itself, low beam steering, and good temperature stability. The inventor has discovered that a quartz crystal for surface acoustic wave propagation, the crystal having a substantially planar surface defined by the Euler angles lambda (λ) equal to substantially 45° and mu (µ) equal to substantially 55°; and means for defining an acoustic wave propagation direction in the plane of the surface at a Euler angle theta (ϑ) equal to between 10° and minus 30°, an orientation which has not been previously disclosed, provides the needed advantages as set forth above when electrodes are placed on a quartz crystal. The means for defining the acoustic wave propagation direction may be a mark, or it may be the applied electrodes. It also allows the construction of unidirectional surface acoustic wave device comprising two interdigitated electrodes per wavelength on the planar surface of a quartz crystal according to the invention to obtain unidirectional transmission at the Euler angle theta (ϑ) with a desired symmetrical input conductance function and a flat susceptance region. See US-A-4,599,587 for a detailed description of the desired conductance and susceptance.

The crystal may be in the form of a wafer for constructing surface acoustic wave devices.

The present invention will be described more completely in conjunction with the accompanying drawings, in which:
Figure 1 is a representation of the Euler angle of lambda (λ) and the direction in which it is moved from X to X₁ a distance of about 45° in forming the crystal cut of the present invention;
Figure 2 is a representation of the Euler angle lambda in its moved position and the Euler angle mu and the direction from Z to Z₁ in which it is moved by about 55°;
Figure 3 is a representation of the Euler angle theta or the direction of acoustic wave propagation in the crystal, cut according to the angles lambda and mu in Figures 1 and 2, in a direction of from about 10° to about minus 30°; and,
Figure 4 illustrates the side view of a surface acoustic wave device having two interdigitated electrodes per wavelength on the planar surface and having the quartz crystal cut with the Euler angles of lambda of about 45° and mu of about 55°, and the direction of propagation Euler angle theta of between about plus 10° and about minus 30°.

The newly discovered crystal cut with the Euler angles lambda equal to substantially 45° and mu equal to substantially 55° and the wave propagation direction theta equal to between 10° and minus 30° on a quartz crystal provides improved performance of surface acoustic wave (SAW) devices. There are many different types of quartz crystal substrates which are usually cut in the form of wafers which are thin slices having two substantially planar surfaces with at least one of the planar surfaces cut with a particular orientation that gives a cut having desired features including tempeature stability of frequency and delay, velocity, coupling coefficient, and the like. The surface of the crystal on which the electrodes are to be placed is made flat and smooth before the electrodes are placed upon it.

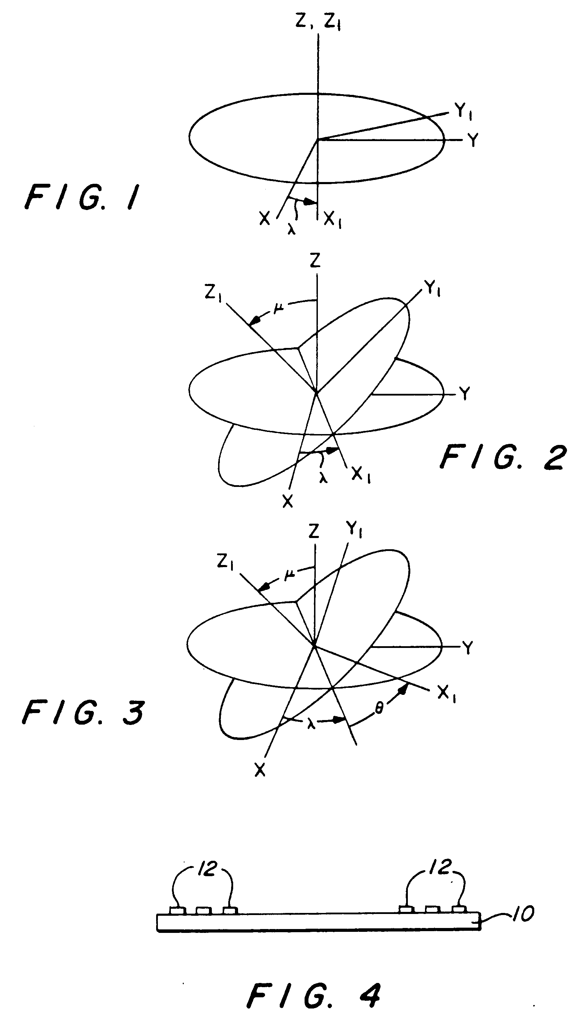

Figure 4 illustrates the quartz crystal 10 with the novel acoustic wave propagation orientation on the cut of from plus 10° to minus 30° and illustrates two electrodes 12 per wavelength placed thereon to form the novel acoustic wave device of the present invention which has unidirectional wave propagation characteristics. The transducer has a symmetric conductance function and can have a flat susceptance region. This structure can be obtained because the separation of the centres of the transduction and reflection on the newly discovered orientation is approximately 45°, the desired separation as set forth in US-A-4,599,587.

As used herein the Euler angles are for right alpha quartz and related to an XYZ coordinate system as described with reference to the accompanying drawings, and the XYZ coordinate system follows the 1978 IEEE Standard on Piezoelectricity. According to this reference system the +Z direction is chosen parallel to the optic (trigonal) axis. The X direction is chosen to be parallel to an electric (digonal) axis with the positive sense in right quartz being towards the end of the axis modified by the s and x faces. The Y direction is then chosen so as to form a right-handed coordinate system. In left quartz the sense of the X direction is reversed, so that the positive sense is away from the modified end of the electric axis, but still the Y direction is selected to keep a right-handed system. Adoption of this standard results in all the piezoelectric constants of left quartz, to which the invention is equally applicable, having the opposite sign to those of right quartz.

## Claims

1. A quartz crystal for surface acoustic wave propagation, the crystal having a substantially planar cut surface defined by the Euler angles lambda (λ) equal to substantially 45° and mu (µ) equal to substantially 55°; and means for defining an acoustic wave propagation direction in the plane of the surface at a Euler angle theta (ϑ) equal to between 10° and minus 30°.

2. A unidirectional surface acoustic wave device comprising two interdigitated electrodes per wavelength on the planar surface of a quartz crystal according to claim 1 to obtain unidirectional transmission at the Euler angle theta (ϑ).

3. A device according to claim 2, in which the crystal is in the form of a wafer (10).

## Patentansprüche

1. Ein Quartzkristall für die oberflächenakustische Wellenausbreitung mit einer im wesentlichen eben geschnittenen Oberfläche, die durch die Eulerwinkel lambda (λ) gleich in wesentlichen 45° und mü (µ) gleich im wesentlichen 55° definiert ist, und mit Mitteln zur Festlegung einer akustischen Wellenausbreitungsrichtung in der Ebene der Fläche bei einem Eulerwinkel theta (ϑ) gleich zwischen 10° und minus 30°.

2. Ein unidirektionales Oberflächenakustikwellengerät mit zwei digital verbundenen Elektroden pro Wellenlänge auf der ebenen Oberfläche eines Quartzkristalls nach Anspruch 1, um eine unidirektionale Übertragung bei dem Eulerwinkel theta (ϑ) zu bekommen.

3. Ein Gerät nach Anspruch 2, bei dem der Kristall die Form einer Scheibe (10) hat.

## Revendications

1. Un cristal de quartz pour la propagation d'une onde acoustique de surface, le cristal ayant une surface de coupe sensiblement plane définie par les angles d'Euler lambda (λ) sensiblement égal à 45° et mu (µ) sensiblement égal à 55°, et des moyens pour définir une direction de propagation de l'onde acoustique dans le plan de la surface avec un angle d'Euler thêta (ϑ) compris entre 10° et -30°.

2. Un dispositif unidirectionnel d'onde acoustique de surface composé de deux électrodes entrecroisées par longueur d'onde sur la surface plane d'un cristal de quartz selon la revendication 1 de façon à obtenir une transmission unidirectionnelle selon l'angle d'Euler thêta (ϑ).

3. Un dispositif suivant la revendication 2, dans lequel le cristal a la forme d'une pastille (10).
